(19) Europäisches Patentamt
European Patent Office
Office européen des brevets

(11) **EP 4 679 106 A1**

(12) **EUROPEAN PATENT APPLICATION**

(43) Date of publication:
**14.01.2026 Bulletin 2026/03**

(21) Application number: **24187019.5**

(22) Date of filing: **08.07.2024**

(51) International Patent Classification (IPC):
**G01R 27/26** (2006.01)     **G01R 31/26** (2020.01)
**H01L 21/66** (2006.01)     **G01R 29/24** (2006.01)

(52) Cooperative Patent Classification (CPC):
**G01R 31/2621; G01R 27/2605; G01R 29/24;
G01R 31/2608; H01L 22/14**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(71) Applicant: **Infineon Technologies AG
85579 Neubiberg (DE)**

(72) Inventors:
• **AICHINGER, Thomas
9583 Faak am See (AT)**

• **SLAMNIG, Walter Johann
9582 Latschach (AT)**
• **RABELO ROCHA, Pablo
9500 Villach (AT)**
• **PETERS, Dethard
91315 Höchstadt (DE)**

(74) Representative: **Infineon Patent Department
Intellectual Property
Infineon Technologies AG
Postfach 22 16 44
80506 München (DE)**

(54) **METHOD FOR MEASURING AN INTERNAL CAPACITANCE OF A TRANSISTOR DEVICE**

(57)    A method and an evaluation circuit are disclosed. The method includes applying a voltage with a predefined voltage level between a first load path node (11) and a second load path node (12) of a transistor device (1); measuring a voltage between a control node (13) and the second load path node (12) to obtain a voltage measurement value; and determining at least one of an electric charge stored in a first internal capacitance (21) or a capacitance value (C21) of the internal capacitance (21) effective between the first load path node (11) and the control node (13) based on the first voltage measurement value and based on a capacitance value of a second internal capacitance (31) effective between the control node (13) and the second load path node (12).

FIG 1

**Description**

**TECHNICAL FIELD**

The present disclosure relates to a method for measuring an internal capacitance of a transistor device.

**BACKGROUND**

An insulated gate transistor device such as a MOSFET or an IGBT inevitably includes internal capacitances between load path nodes and a control node. A first internal capacitance that is effective between the control node and a first load path node is usually referred to as gate-drain capacitance in a MOSFET and gate-collector capacitance in an IGBT. A second internal capacitance that is effective between the control node and a second load path node is usually referred to as gate-source capacitance in a MOSFET and gate-emitter capacitance in an IGBT. Usually, an insulated gate transistor device is driven by applying a voltage between the control node and the second load path node.

Both the first internal capacitance and the second internal capacitance define the switching characteristic of the transistor devices. Furthermore, the first internal capacitance and the charge stored in the first internal capacitance when a certain voltage is applied between the first and second load path nodes gives an indication about the parasitic-turn-on tendency of the transistor device and the reliability of a gate dielectric in an off-state of the transistor device.

Thus, there is a need to measure internal capacitances of a transistor device and, in particular, to measure the first internal capacitance or an electric charge stored on the first internal capacitance when a certain voltage is applied between the first and second load path node.

**SUMMARY**

One example relates to a method. The method includes applying a voltage with a predefined voltage level between a first load path node and a second load path node of a transistor device, measuring a voltage between a control node and the second load path node of the transistor device to obtain a voltage measurement value, determining at least one of an electric charge stored in a first internal capacitance or a capacitance value of a first internal capacitance effective between the first load path node and the control node based on the first voltage measurement value and based on a capacitance value of a second internal capacitance effective between the control node and the second load path node.

Another example relates to an evaluation circuit that is configured to perform the method.

Those skilled in the art will recognize additional features and advantages upon reading the following detailed description, and upon viewing the accompanying drawings.

**BRIEF DESCRIPTION OF THE DRAWINGS**

The present disclosure is illustrated by way of example, and not by way of limitation, in the figures of the accompanying drawings in which like reference numerals refer to similar or identical elements. The elements of the drawings are not necessarily to scale relative to each other. The features of the various illustrated examples can be combined unless they exclude each other.

Figure 1 illustrates a transistor device that includes a first internal capacitance and a second internal capacitance according to one example;

Figure 2 illustrates a transistor device that includes a first internal capacitance and a second internal capacitance according to another example;

Figure 3 illustrates one example of a method for determining an electric charge stored in the first internal capacitance, wherein the method includes applying a voltage between a first load path node and a second load path node and measuring a voltage between a control node and the second load path node;

Figure 4 illustrates one example of a method for applying the voltage between the first load path node and the second load path node and measuring the voltage between the control node and the second load path node;

Figure 5 illustrates one example of a method for determining the second internal capacitance;

Figure 6 illustrates a modification of the method according to Figure 4, which includes connecting an internal capacitance between the control node and the second load path node;

Figure 7 illustrates one example of an evaluation circuit that is configured to perform the method according to Figure 3;

Figure 8 illustrates one example of the evaluation circuit in detail;

Figure 9 illustrates one example of an evaluation circuit that includes a first parasitic capacitance and a second parasitic capacitance;

Figure 10 schematically illustrates a semiconductor body in which a vertical transistor device is integrated;

Figure 11 illustrates a wafer which includes a plurality of semiconductor bodies and an evaluation circuit coupled to the transistor device integrated in one of the semiconductor body for determining the first internal capacitance; and

Figure 12 illustrates one of the semiconductor bodies of the wafer according to Figure 10 in detail.

## DETAILED DESCRIPTION

The examples described herein provide for a method for determining an electric charge stored in an internal capacitance of a transistor device and/or for determining a capacitance value of the internal capacitance of the transistor device. The method is capable of being performed on a wafer level, that is, the electric charge stored in internal capacitances of a plurality of transistor devices arranged on the same wafer can be measured before the wafer is separated into the individual transistor devices.

Although specific examples have been illustrated and described herein, it will be appreciated by those of ordinary skill in the art that a variety of alternate and/or equivalent implementations may be substituted for the specific examples shown and described without departing from the scope of the present invention. This application is intended to cover any adaptations or variations of the specific examples discussed herein. Therefore, it is intended that this invention be limited only by the claims and the equivalents thereof.

It should be noted that the methods and devices including its preferred embodiments as outlined in the present document may be used stand-alone or in combination with the other methods and devices disclosed in this document. In addition, the features outlined in the context of a device are also applicable to a corresponding method, and vice versa. Furthermore, all aspects of the methods and devices outlined in the present document may be arbitrarily combined. In particular, the features of the claims may be combined with one another in an arbitrary manner.

It should be noted that the description and drawings merely illustrate the principles of the proposed methods and systems. Those skilled in the art will be able to implement various arrangements that, although not explicitly described or shown herein, embody the principles of the invention and are included within its spirit and scope. Furthermore, all examples and embodiments outlined in the present document are principally intended expressly to be only for explanatory purposes to help the reader in understanding the principles of the proposed methods and systems. Furthermore, all statements herein providing principles, aspects, and embodiments of the invention, as well as specific examples thereof, are intended to encompass equivalents thereof.

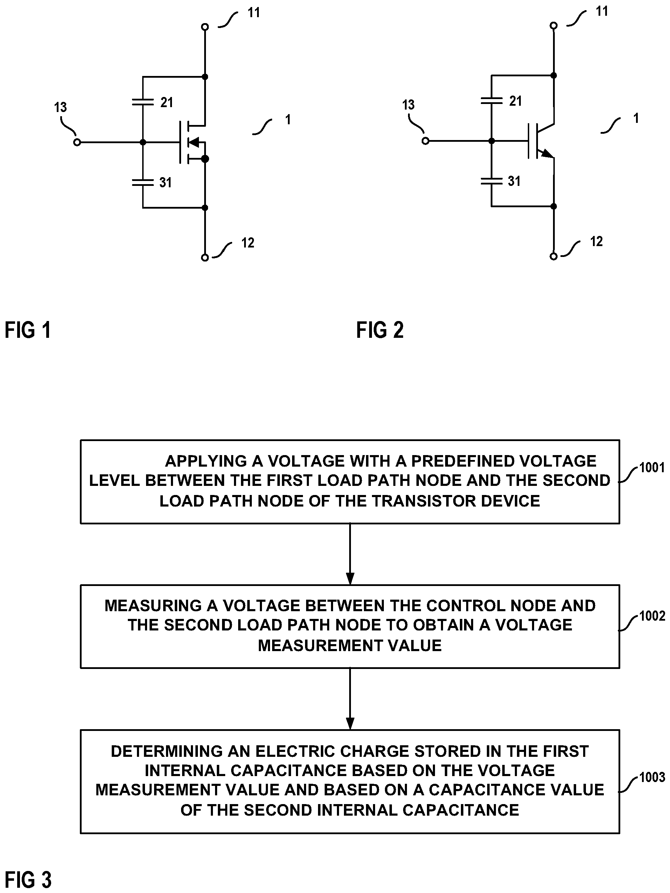

Referring to the above, one example disclosed herein relates to a method for determining an electric charge stored in an internal capacitance of a transistor device. Examples of transistor devices that include internal capacitances are illustrated in Figures 1 and 2.

Referring to Figures 1 and 2, each of the transistor devices includes a first load path node 11, a second load path node 12, a control node 13, a first internal capacitance 21, and a second internal capacitance 31. The first internal capacitance 21 is effective between the first load path node 11 and the control node 13, and the second internal capacitance 31 is effective between the second load path node 12 and the control node 13.

Each of the transistor devices illustrated in Figures 1 and 2 is a voltage-controlled transistor device that is in an on-state or an off-state dependent on a voltage level of a control voltage (drive voltage) applied between the control node 13 and the second load path node 12. The transistor device is in the on-state when the control voltage is higher than a threshold voltage of the transistor device, and the transistor device is in the off-state when the control voltage is lower than the threshold voltage of the transistor device. In the on-state, the transistor device is configured to conduct a current between the first and second load path node 11, 12. In the off-state, the transistor device is configured to block voltage levels of a load path voltage applied between the first and second load path nodes 11, 12 that are lower than a voltage blocking capability of the transistor device. The voltage blocking capability defines the maximum voltage level of the load path voltage the transistor device can withstand. The voltage blocking capability is dependent on the specific implementation of the transistor device and is in a range of between several 10 volts and several kilovolts, for example.

According to the example illustrated in Figure 1, the transistor device may be implemented as a MOSFET. In a MOSFET, the control node 13 is usually referred to as gate node, the first load path node 11 is usually referred to as drain node, and the second load path node is usually referred to as source node. Accordingly, the first internal capacitance 21 is usually referred to as gate-drain capacitance, the second internal capacitance 31 is usually referred to as gate-source capacitance, and the control voltage is usually referred to as gate-source voltage.

The transistor device in Figure 1 is represented by its circuit symbol. The circuit symbol shown in Figure 1 represents an N-type enhancement MOSFET. This, however, is only an example. Anything explained in the following applies to a P-type enhancement MOSFET equivalently.

According to the example illustrated in Figure 2, the transistor device may be implemented as an IGBT. In an IGBT, the control node 13 is usually referred to as gate node, the first load path node 11 is usually referred to as collector node, and the second load path node is usually referred to as emitter node. Accordingly, the first internal capacitance 21 is usually referred to as gate-collector capacitance, the second internal capacitance 31 is usually referred to as gate-emitter capacitance, and the control voltage is usually referred to as gate-emitter voltage.

It should be noted that the first and second internal capacitances 21, 22 are internal capacitances of the respective transistor device. However, in order to ease understanding of the method explained in the following, in Figures 1 and 2, the first and second internal capacitances 21, 22 are represented by capacitors that are shown in addition to the circuit symbol of the respective transistor device.

In particular the first internal capacitance 21 may have a significant impact on the electrical behavior of the transistor device. It is therefore desirable to determine the first internal capacitance and/or the electrical charge stored in the first internal capacitance when a certain load path voltage is applied between the first and second load path nodes 11, 12. One example of a method for determining the electric charge stored in the first internal capacitance when a certain load path voltage is applied between the first and second load path nodes 11, 12 is illustrated in Figure 3.

Referring to Figure 3, the method includes (1001) applying a load path voltage with a predefined voltage level between the first load path node 11 and the second load path node 12 of the transistor device 1; (1002) measuring a voltage between the control node 13 and the second load path node 12 to obtain a voltage measurement value; and (1003) determining an electric charge stored in the first internal capacitance 21 based on the voltage measurement value and based on a capacitance value of the second internal capacitance 31.

The method according to Figure 2 relies on the fact that the first and second internal capacitances 21, 31 form a capacitive voltage divider between the first and second load path nodes 11, 12. Thus, when a certain load path voltage is applied between the first and second load path nodes 11, 12 an electric charge Q21 stored in the first internal capacitance 21 equals an electric charge Q31 stored in the second internal capacitance 31,

$$Q21 = Q31 \hspace{5cm} (1).$$

In the following, the electric charge Q21 stored in the first internal capacitance 21 is referred to as first electric charge, and the electric charge Q31 stored in the second internal capacitance 31 is referred to as second electric charge.

The second electric charge 31 is given by a capacitance value C31 of the second internal capacitance 31 multiplied with a voltage V31 across the second internal capacitor 31,

$$Q31 = Q21 = V31 \cdot C31 \hspace{4cm} (2).$$

Thus, by applying a load path voltage between the first and second load path nodes 11, 12 such that the first and second internal capacitances 21, 31 are charged and measuring the resulting voltage V31 across the second internal capacitances 31, the electric charge stored in the first internal capacitance 21 can be obtained using equation (2).

Determining the electric charge stored in the first internal capacitance using equation (2) requires knowledge of the capacitance value C31 of the second internal capacitance 31. One example of a method for determining the capacitance value C31 of the second internal capacitance 31 is explained herein further below.

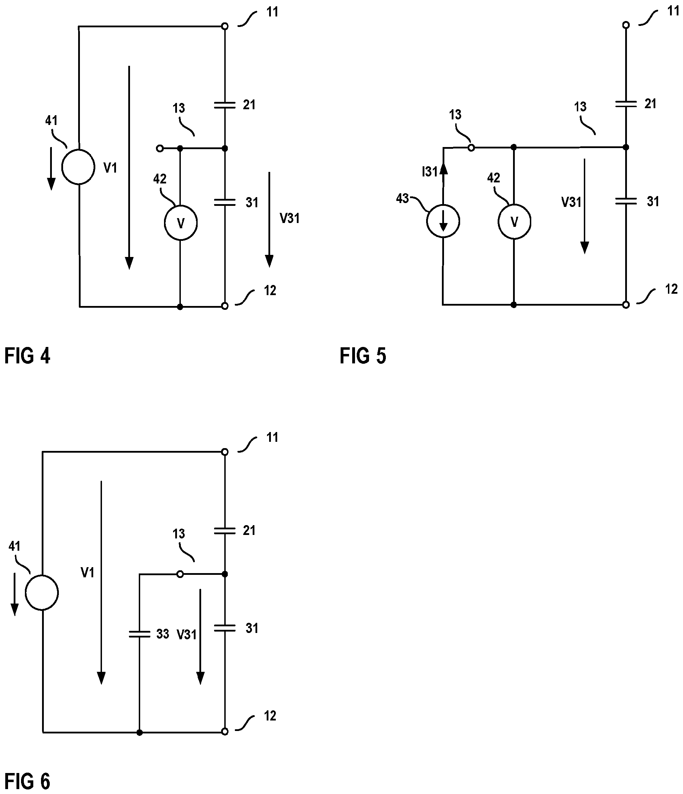

Figure 4 schematically illustrates one example for performing the method according to Figure 3. It should be noted that in Figure 4 and the following figures only the first and second internal capacitances 21, 31 of the transistor device are illustrated. The transistor device is a transistor device according to any of the examples explained herein before.

As can be seen from Figure 4, the method includes applying a load path voltage having a predefined first voltage level V1 between the first and second load path nodes 11, 12 and measuring the voltage level V31 of the voltage across the second internal capacitance 31. Applying the load path voltage may include using a voltage source V41 connected to the load path nodes 11, 12. Measuring the voltage across the second internal capacitance 31 may include using a voltage sensor V42 connected between the control node 13 and the second load path node 12.

According to one example, based on the determined electric charge Q21 stored in the first internal capacitance 21, a capacitance value C21 of the first internal capacitance 21 is determined using a difference between the voltage level of the load path voltage V1 and the measured voltage V31 across the second internal capacitance 31 as follows,

$$C21 = \frac{Q21}{V1-V31} \tag{3},$$

where Q21 denotes the determined electric charge stored in the first internal capacitance 21, V1 denotes the voltage level of the load path voltage applied between the first and second load path nodes 11, 12, and V31 denotes the voltage level of the measured voltage across the second internal capacitance 31.

The voltage level V1 of the load path voltage applied in the process of determining the electric charge stored in the first internal capacitance is lower than a breakdown voltage of the transistor device. According to one example, the voltage level V1 is selected from a range of between 20% and 90%, in particular between 50% and 80% of the breakdown voltage of the transistor device. The voltage blocking capability is dependent on the specific type of the transistor device and is between several 10 V and several kilovolts, such as between 40V and 10 kV, for example.

Referring to equation (2), determining the electric charge Q31 stored in the second internal capacitance 31 includes using a previously determined capacitance value C31 of the second internal capacitance 31. Determining the capacitance value C31 of the second internal capacitance C31 may include charging the second internal capacitance 31 with a predefined electric charge ΔQ31 and measuring a voltage difference ΔV31 resulting from charging the second internal capacitance 31 with the predefined electric charge ΔQ31. The capacitance value C31 is then given by the quotient of the electric charge ΔQ31 and the voltage difference ΔV31,

$$C31 = \frac{\Delta Q31}{\Delta V31} \tag{4},$$

where ΔQ31 denotes the charge provided to the second internal capacitance 31, and ΔV31 denotes the voltage difference between the voltage across the second internal capacitance 31 after charging the second internal capacitance 31 with ΔQ31 and the voltage across the second internal capacitance 32 before charging the second internal capacitance 31 with ΔQ31.

It should be noted that equation (4) applies equivalently when the second internal capacitance 31 is discharged by a certain amount ΔQ31 of charge. In this case, the electric charge stored in the second internal capacitance 31 is reduced by the predefined amount ΔQ31, so that the voltage is reduced by ΔV31.

According to one example charging the second internal capacitance 31 with the predefined electric charge ΔQ31 includes driving a current with a predefined current level I31 for a predefined time period Δt into the second internal capacitance 31, so that the predefined electric charge ΔQ31 is given by the current level I31 multiplied with the time period Δt,

$$\Delta Q31 = I31 \cdot \Delta t \tag{5}.$$

Figure 5 schematically illustrates one example of a method for determining the capacitance value C31 of the second internal capacitance 31 in accordance with the example explained before. Referring to Figure 5, the current with the current level I31 for charging the second internal capacitance 31 is provided by a current source 43 connected between the control node 13 and the second load path node 12. The voltage difference ΔV31 resulting from the charging of the second internal capacitance 31 may be measured using the same voltage sensor 42 that is used for measuring the voltage V31 across the second internal capacitance 31 in the method illustrated in Figure 4.

Referring to the above, during normal operation, the transistor device may switch on when a drive voltage (control voltage) higher than the threshold voltage is applied between the control node 13 and the second load path node 12. Furthermore, during normal operation, when it is desired to maintain the transistor device in the off-state, a drive voltage is applied between the control node 13 and the second load path node 12 that is lower than the threshold voltage.

According to one example, in the method explained above for determining the electric charge Q21 stored in the first internal capacitance 21, the load path voltage V1 applied between the first and second load path nodes 11, 12 is selected such that the resulting voltage V31 between the control node 13 and the second load path node 12 is lower than the threshold voltage of the transistor device in order to prevent the transistor device from switching on. A ratio between capacitance values C21, C31 of the first and second internal capacitances 21, 23 is at least roughly known before the measuring process, so that based on this ratio of the capacitance values the voltage level V1 of the load path voltage applied in the measuring process can be adapted suitably in order to prevent the voltage level of the control voltage V31 from reaching the threshold voltage.

Usually, the capacitance value of the second internal capacitance 31 of the transistor device is much higher than the capacitance value of the first internal capacitance 21. Thus, in accordance with the capacitive divider ratio of the capacitive voltage divider formed by the first and second internal capacitance 21, 31, the voltage V31 between the control node 13 and the second load path node 52 is usually much lower than the voltage between the first load path node 51 and the control node 13 when the load path voltage V1 is applied between the first and second load path nodes 51, 52. According to one example, the transistor device is implemented such that the capacitance value of the first internal capacitance 21 is less than 10%, or even less than 1% of the capacitance value of the second internal capacitance 31.

According to one example illustrated in Figure 6 a capacitor 33 is connected in parallel with the second internal capacitance 31 when determining the charge Q21 stored in the first internal capacitance 21. This capacitor 33 is also referred to as further capacitor or external capacitor in the following. Connecting the further capacitor 33 in parallel with the second internal capacitance 31 increases the overall capacitance between the control node 13 and the second load path node 12 and, at a given voltage level V1 of the load path voltage, reduces the voltage V31 between the control node 13 and the second load path node 12 as compared to the scenario in which only the second internal capacitance 31 is present between the control node 13 and the second load path node 12. This may either help to increase the safety margin between the voltage level V31 of the control voltage and the threshold voltage when a certain voltage level V1 of the load path voltage is applied, or make it possible to increase the voltage level V1 of the load path voltage at a given safety margin.

According to one example, the further capacitor 33 connected in parallel with the second internal capacitance 31 is selected such that an overall capacitance C3 between the control node 13 and the second load path node 12, which is given by the capacitance value of the second internal capacitance 32 plus the capacitance of the further capacitor 33,

$$C3 = C31 + C33 \qquad\qquad (6),$$

is high enough relative to the capacitance value of the first internal capacitance 22 that the voltage V31 between the control node 13 and the second load path node 12 is safely below the threshold voltage of the transistor device, so that, during the measurement, the transistor device remains in the off-state. According to one example, the capacitance value of the further capacitor 33 is in a range of between the capacitance value of the second internal capacitance 31 and 10 times the capacitance value of the second internal capacitance 31.

In the method illustrated in Figure 6, the charge stored in the first internal capacitance C21 is given by the charge stored in the parallel circuit including the second internal capacitance 31 and the capacitor 3,

$$Q21 = Q31 = V31 \cdot C3 = V31 \cdot (C31 + C33) \qquad\qquad (7),$$

where C33 denotes the capacitance of the further capacitor 33.

According to one example, the method explained hereinabove is performed by an evaluation circuit (evaluation equipment) 5 that is connected to the first and second load path nodes 11, 12, and the control node 13.

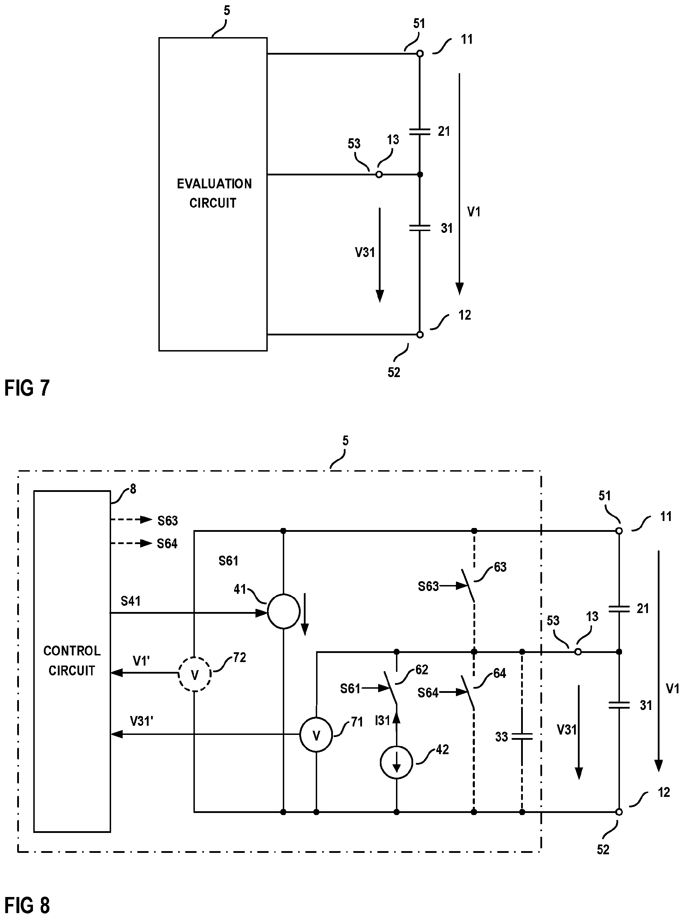

Figure 7 schematically illustrates a block diagram of an evaluation circuit 5 configured to perform the method explained above for determining the charge stored in the first internal capacitance 21. Referring to Figure 7, the evaluation circuit 5 includes three terminals (which may also be referred to as pins), a first terminal 51 connected to the first load path node 11, a second terminal 52 connected to the second load path node 12, and a third terminal 53 connected to the control node 13. A more detailed example of the evaluation circuit 5 is illustrated in Figure 8.

Referring to Figure 8, the evaluation circuit 5 includes a control circuit 8 that is configured to control operation of the evaluation circuit 5. In particular, the control circuit 8 is configured to receive measurement signals from voltage sensors of the evaluation circuit 5 and to control voltage and current sources of the evaluation circuit 5. This is explained in detail in the following.

In the example illustrated in Figure 8, the evaluation circuit 5 includes a controllable voltage source 41 that is connected between the first and second terminals 51, 52 and, therefore, between the first and second load path nodes 11, 12 of the transistor device. The voltage source 41 can be activated and deactivated by a control signal S41 received from the control circuit 8. When the voltage source 41 is activated, it applies a load path voltage with a predefined voltage level V1 between the first and second terminals 51, 52 and the first and second load path nodes 11, 12. When the voltage source 41 is deactivated it provides for a high electric resistance between the first and second terminals 51, 52 so that the presence of the voltage source 41 does not affect the charging state of the first and second internal capacitances 21, 31.

Referring to Figure 8, the evaluation circuit 5 further includes a voltage sensor 71 that is connected between the third and second terminals 52, 53 and, therefore, the control node 13 and the second load path node 12. The voltage sensor 71 is configured to sense the voltage V31 between the control node 13 and the second load path node 12 and provide a measurement value V31' that represents the measured voltage V31 to the control circuit 8.

Optionally, the evaluation circuit 5 further includes the further capacitor 33. The further capacitor 33 is connected between the third and second terminals 53, 52 and, therefore, between the control node 13 and the second load path node 12.

Furthermore, the evaluation circuit 5 may include a first discharge switch 63 and a second discharge switch 64. The first discharge switch 63 is connected between the first and third terminals 51, 53 and, therefore, the first load path node 11 and the control node 13. The second discharge switch 63 is connected between the third and second terminals 53, 52 and, therefore, the control node 13 and the second load path node 12. Each of the first and second discharge switches 61, 64 receives a respective control signal S63, S64 from the control circuit 8 and is in an on-state or an off-state dependent on the respective control signal S63, S64. When the first discharge switch 63 is in the on-state, it discharges the first internal capacitance 21. Equivalently, when the second discharge switch 64 is in the on-state, it discharges the second internal capacitance 31.

According to one example, the first and second internal capacitances 21, 31 are discharged before the electric charge stored in the first internal capacitance 21 is determined. For this, the control circuit 8 may be configured to switch on the first and second discharge switches 63, 64 in order to discharge the first and second internal capacitances 21, 31 before the electric charge stored in the first internal capacitance 21 is determined. Determining the electric charge stored in the first internal capacitance 21 may include activating the voltage source 41 to apply the load path voltage having voltage level V1 between the first and second load path nodes 11, 12, and measuring the voltage V31 between the control node 13 and the second load path node 12 using the voltage sensor 71. The capacitance value C31 of the second internal capacitance 31 is stored in the control circuit 8 and the control circuit is configured to determine the charge stored in the first internal capacitance 21 in accordance with equation (2) based on the stored capacitance value C31 and the voltage measurement value V31' received from voltage sensor 71.

If the evaluation circuit 5 includes the further capacitor 33, either the capacitance value C33 of the further capacitor 33 is stored in the control circuit 8 in addition to the capacitance value C31 of the first internal capacitance, or the overall capacitance C3 (=C31+C33) is stored in the control circuit 8. In this example, the control circuit 8 is configured to calculate the charge stored in the first internal capacitor 21 in accordance with equation (7) based on the stored capacitance values C31, C33 or C3 and the voltage measurement value V31' received from voltage sensor 71.

According to one example, the control circuit 8 is configured to display the result of determining the charge Q21 stored in the first internal capacitance 21 at a display device (not illustrated) or to communicate the result to another entity, such as another controller, via a suitable communication interface (also not illustrated).

Referring to the above, based on the determined charge Q21 stored in the first internal capacitance 21 the capacitance value C21 of the first internal capacitance 21 can be determined. According to one example, the control circuit 8 is configured to determine the capacitance value C21 in accordance with equation (3), for example. In this example, in addition to the measurement value V31' representing the voltage V31 between the control node 13 and the second load path node 12, the control circuit 8 receives a further voltage measurement value V1' that represents the voltage level V1 of the load path voltage applied between the first and second load path nodes 11, 12 and is configured to calculate the capacitance value C21 based on the determined charge Q21 and the further voltage measurement value V1'. This further voltage measurement value V1' is provided by another voltage sensor 72 connected between the first and second load path nodes 11, 12, for example.

According to one example, the evaluation circuit 5 is further configured to determine the capacitance value C31 of the second internal capacitance 31. For this, the evaluation circuit 5 includes a controllable current source 42 that is connected between the third and second terminals 53, 52 of the evaluation circuit 5 and, therefore, the control node 13 and the second load path node 12 of the transistor device 1. The current source 42 is configured to receive a control signal S42 from the control circuit 8 and is configured to be activated or deactivated based on the control signal S42. In the activated state, the current source 42 provides a current with a predefined current level I31 different from zero. In the deactivated state, the current source 42 does not provide a current (which is equivalent to providing a current with a current level of zero).

For determining the capacitance value C31 of the second internal capacitance 31, the control circuit 8 is configured to activate the current source 42 for a predefined time period Δt, so that the second internal capacitance 31 is charged with a predefined amount of charge ΔQ31. Furthermore, based on the voltage measurement value V31' received from the first voltage sensor 71, the control circuit 8 is configured to determine a voltage difference ΔV31 of the voltage V31 between the control node 13 and the second load path node 12 before and after charging the second internal capacitance 31. Furthermore, the control circuit 8 is configured to determine the capacitance value C31 of the second internal capacitance 31 in accordance with equation (4) based on the predefined amount of charge ΔQ31 and the voltage difference ΔV31.

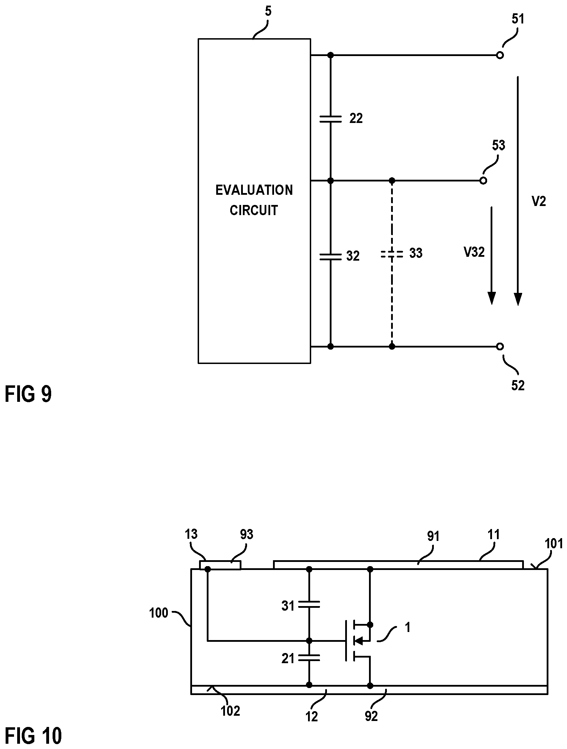

Referring to Figure 9, the evaluation circuit 5 may include a first parasitic capacitance 22 between the first terminal 51 and the third terminal 53 and a second parasitic capacitance 32 between the third terminal 53 and the second terminal 52. Such parasitic capacitances are illustrated as capacitors connected between the respective terminals in the example illustrated in Figure 9. The remainder of the evaluation circuit is not illustrated in detail in Figure 9. The parasitic capacitances 22, 32 of the evaluation circuit 5 can distort the result of determining the charge Q21 stored in the first internal capacitance 21 and can distort the result of determining the capacitance value C31 of the second internal capacitance 31.

According to one example, before the transistor device is connected to the evaluation circuit 5 and the charge Q21 stored in the first internal capacitance 21 is determined (a) a charge Q22 stored in the first parasitic capacitance 22 is determined, and (b) a capacitance value C30 of a capacitance between the third and second terminals 13, 12 of the evaluation circuit 5 are determined in an open-loop process, in which the transistor device is not connected to the first, second, and third terminals 51, 52, 53 of the evaluation circuit 5. The capacitance value C30 of the capacitance between the third and second terminals 53, 52 of the evaluation circuit 5 is either given by a capacitance value C32 of the second parasitic capacitance 32, when the evaluation circuit is devoid of the further capacitance 33,

$$C30 = C32 \tag{8a},$$

or is given by the capacitance value C32 of the second parasitic capacitance 32 plus the capacitance value C33 of the further capacitor 33,

$$C30 = C32 + C33 \tag{8b}.$$

In the open-loop process, the capacitance value C30 of the overall capacitance between the third and second terminals 53, 52 can be determined in the same way as explained with reference to equations (4) and (5) hereinabove, that is, based on charging/ discharging the capacitance between the first and second terminals 52, 53 with a predefined charge and measuring the voltage increase/decrease resulting from the charging process.

In the open-loop measurement process, for determining the charge Q22 stored in the first parasitic capacitance 22, a voltage V2 is applied between the first and second terminals 51, 52 of the evaluation circuit 5. According to one example, a voltage level of this voltage V2 is essentially equal to the voltage level of the voltage V1 applied between the first and second terminals in the transistor measurement process, that is, when the transistor device is connected to the evaluation circuit 5 and the charge stored in the first internal capacitance 21 of the transistor device is measured. According to one example, "at least approximately equal" includes that the voltage level of the voltage V2 applied in the open-loop measurement process is in a range of between 75% and 125% of the voltage level of the voltage V1 applied to the transistor device in the measurement process.

Determining the charge Q22 stored in the first internal capacitance 22 includes measuring a voltage V32 between the second and third terminals 52, 53 of the evaluation circuit 5. The charge Q22 stored in the first internal capacitance 22 is dependent on the voltage level of the voltage V32 between the second and third terminals 52, 53 and is given by

$$Q22 = V32 \cdot C30 \tag{9},$$

where C30 denotes the capacitance value of the capacitance between the third and second terminals 53, 52 in the open loop process.

In the transistor measurement process, that is, when the transistor device is connected to the evaluation circuit 5, an overall charge Q2 stored by an overall capacitance C2 between the first terminal 51 and the third terminal 53 is determined. This includes applying the load path voltage V1 between the first and second terminals 51, 52 of the evaluation circuit 5 (and between the first and second load path node 11, 12 of the transistor device), measuring the voltage V31 between the third and second terminals 53, 52 (and between the control node 13 and the second load path node 12 of the transistor device), and determining the overall charge Q2 dependent on the measured voltage V31 and a capacitance value C3 of an overall capacitance between the third and second terminals 53, 52,

$$Q2 = V31 \cdot C3 \tag{10},$$

where Q2 denotes the overall charge stored between the first and third terminals 51, 53, V31 denotes the measured voltage between the third and second terminals 53, 52, and C3 is the overall capacitance between the third and second terminals 53, 52. This overall capacitance C3 includes the capacitance value of the second internal capacitance 22 plus the capacitance value of the second parasitic capacitance 32 plus the capacitance value C33 of the optional further capacitor 33. The method further includes determining the capacitance value C3 of the overall capacitance between the third and second terminals 53, 52. This overall capacitance can be determined in the same way as explained with reference to equations (4) and (5) hereinabove, that is, based on charging/discharging the capacitance between the first and second terminals 52, 53 with a predefined charge and measuring the voltage increase/decrease resulting from the charging process.

As explained above, the first internal capacitance 21 is usually much lower than the second eternal capacitance 31, so that during the transistor measurement process the voltage V31 between the control node 13 and the second load path node 12 is much lower than the voltage across the first internal capacitance 21 and may be less than 1% of the load path voltage. According to one example, in the evaluation circuit 5 according to Figure 9, a capacitance value C22 of the first parasitic capacitance 22 between the first and third terminals 51, 53 is much lower than a capacitance value C30 of the capacitance between the third and second terminals 53, 52 of the evaluation circuit 5, so that a capacitive divider ratio of the capacitive voltage divider with the first and second internal capacitances 21, 31 in the transistor device essentially equals a capacitive divider ratio of the capacitor voltage divider with the first and second parasitic capacitances 22, 32 and the optional further capacitor 33 of the evaluation circuit 5. In this case, if the voltage level of the voltage V2 applied between the first and second terminals 51, 52 in the open-loop process approximately equals the voltage level of the voltage V1 applied between the first and second terminals 51, 52 in the transistor measurement process, the voltages between the first and third load terminals 51, 53 in the open-loop process and the transistor measurement process are approximately equal or, at least, in the same order of magnitude. In this case, in the transistor measurement process, the charge Q21 stored in the first internal capacitance is approximately given by

$$Q21 = Q2 - Q22 = V31 \cdot C3 - Q22 \tag{11},$$

so that the charge Q21 stored in the first internal capacitance 21 can simply be determined based on the overall charge Q2 determined in the transistor measurement process and the charge Q22 determined in the open-loop process.

If the voltage between the first and third terminals 51, 53 in the open-loop process and the transistor measurement process are not approximately equal, the method includes determining the capacitance value C21 of the first internal capacitance 21 based on the capacitance value C22 of the first parasitic capacitance 22 and the capacitance value C2 of the overall capacitance between the third and second terminals 53, 52 when the transistor device is connected to the evaluation circuit 5,

$$C21 = C2 - C22 \tag{12}.$$

According to one example, the capacitance value C22 of the first parasitic capacitance 22 is determined based on the determined charge Q22 in the open-loop process and the voltage between the first and third terminals 51, 53 in the open-loop process,

$$C22 = \frac{Q22}{V2-V32} \tag{13},$$

where Q22 denotes the charge stored between the first and third terminals 51, 53 in the open-loop process and V2-V32, which is the difference between the voltage V2 between the first and second terminals 51, 52 and the voltage between the second and third terminals 53, 52, is the voltage between the first and third terminals 51, 53 in the open-loop process. According to one example, the capacitance value C2 of the overall capacitance between the first and third terminals in the device measurement process is determined based on the determined charge Q2 in the transistor measurement process and the voltage between the first and third terminals 51, 53 in the transistor measurement process,

$$C2 = \frac{Q2}{V1-V31} \tag{14},$$

where Q2 denotes the charge stored between the first and third terminals 51, 53 in the transistor measurement process and V1-V31, which is the difference between the load path voltage V1 and a voltage between the second and third terminals 53, 52, is the voltage between the first and third terminals 51, 53 in the transistor measurement process.

According to one example, the charge Q21 stored in the first internal capacitance 21 is determined based on the determined capacitance C21 and based on the voltage between the first and third terminals 51, 53 in the transistor measurement process,

$$Q21 = C21 \cdot (V1 - V31) \tag{15}.$$

According to one example illustrated in Figure 10, the transistor device is a vertical transistor device. In this case, first and second load path electrodes 91, 92 of the transistor device 1 are arranged above opposite surfaces 101, 102 of a semiconductor body 100 in which active device regions (such as source, body, and drain regions of a MOSFET) of the transistor device 1 are integrated. The transistor device 1 is represented by it is circuit symbol in Figure 10. Just for the purpose of illustration, the circuit symbol according to Figure 10 represents a MOSFET. This, however, is only an example. The transistor device can be implemented in accordance with any of the examples explained hereinabove. The active device regions of the transistor device 1 can be integrated in the semiconductor body 100 in a conventional way. Integrating active device regions of a transistor device in a semiconductor body is commonly known, so that no further explanation is required in this regard.

In the example illustrated in Figure 10, a first load path electrode 91 is formed above a first surface 101 of the semiconductor body 100, and a second load path electrode 92 is formed above a second surface 102 of the semiconductor body 100. The first load path electrode 91 is connected to the first load path node 11 or forms the first load path node 11 of the transistor device, and the second load path electrode 92 is connected to the second load path node 12 or forms the second load path node 12 of the transistor device. In a MOSFET, for example, the first load path electrode 91 is a source electrode and the second load path electrode 92 is a drain electrode.

Referring to Figure 10, the transistor device further includes a control electrode 93. The control electrode 93 is connected to the control node 13 or forms the control node 13 of the transistor device. The control electrode 93 is formed above one of the first and second surfaces 101, 102. According to one example illustrated in Figure 10, the control electrode 91 is formed above the same surface as the first load path electrode 91, which is the first surface 101 in the example illustrated in Figure 10.

In a transistor device of the type illustrated in Figure 10, the load path voltage V1 for determining the charge Q21 stored in the first internal capacitance 21 is applied between the first and second load path electrodes 91, 92 formed above the opposite first and second surfaces 101, 102.

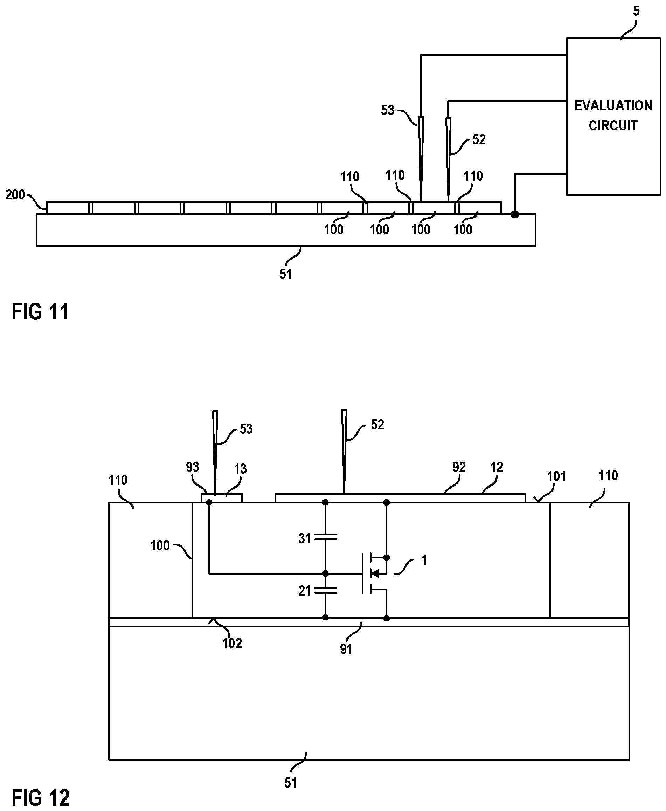

It is commonly known that a plurality of transistor devices can be formed based on the same semiconductor wafer which is finally subdivided to form a plurality of devices. According to one example, the method explained herein before for determining the charge Q21 stored in the first internal capacitance 21 of one transistor device is performed on a wafer level. That is, the method is carried out when a plurality of transistor devices are still part of a common wafer. This is explained with reference to Figures 11 and 12 in the following.

Figure 11 schematically illustrates a wafer 200 that includes a plurality of semiconductor bodies 100 that each has active device regions of a vertical transistor device integrated therein. According to one example, each of the semiconductor bodies 100 is formed by a respective portion of a contiguous monocrystalline semiconductor layer of the wafer 200. Referring to Figure 11, kerf regions 110 are arranged between the semiconductor bodies 100 on the wafer 200. At the end of the manufacturing process, the wafer 200 is separated along the kerf regions 110, which are at least partially removed when the wafer 200 is separated.

The semiconductor bodies 100 are only schematically illustrated in Figure 11. Control and load path electrodes of the transistor devices, for example, are not shown. Furthermore, Figure 11 schematically illustrates an evaluation circuit (evaluation equipment) 5 that is configured to determine the electrical charge stored in each of the transistor devices when a respective voltage is applied between the first and second load path nodes of the respective transistor device.

Figure 12 schematically illustrates one portion of the wafer 200 that includes one semiconductor body 100 with active regions of one transistor device 1 integrated therein and that includes the first load path electrode 92 and the control electrode 93 above the first surface 101 and the second load path electrode 91 above the second surface 102 opposite the first surface. According to one example, the first load path electrodes 91 of the transistor devices 1 formed on the same wafer 200 is a contiguous electrode. This contiguous electrode is separated to form the first load path electrodes 91 of the individual transistor devices 1 when the wafer 200 is separated.

Referring to the above, the evaluation circuit (evaluation equipment) 5 includes first, second, and third terminals for connecting to the first load path electrode 91, the second load path electrode 92, and the control electrode 93. In the example illustrated in Figures 11 and 12, the first terminal 51 is formed by an electrically conducting carrier on top of which the wafer 200 is arranged such that the first load path electrodes 91 of the individual transistor devices 1 are in contact with the carrier. The electrically conducting carrier forming the first terminal 51 of the evaluation circuit 5 may also be referred to as chuck.

The wafer 200 may be held in place on top of the carrier in various ways. According to one example, the carrier includes through holes (not illustrated) and is connected to a vacuum pump (also not illustrated). The vacuum pump is configured, through the through holes, to generate a vacuum between the wafer 200 and the carrier in order to hold the wafer 200 in place on top of the carrier.

Referring to Figures 11 and 12, the second and third terminals 52, 53 are implemented as probes (needles). The needle-shaped second terminal 52 is configured to be brought in electrical contact with the second load path electrode 92 of a transistor device 1 and the needle-shaped third terminal 53 is configured to be brought in electrical contact with the control electrode 93 of the respective transistor device 1 for measuring the charge stored in the first internal capacitance 21 in the way explained herein before.

According to one example, the plurality of transistor devices 1 formed on the wafer 200 are measured successively. That is, at each time a load path voltage V1 is applied between the first and second load path nodes 11, 12 of only one of the transistor devices 1 formed on the wafer 200.

According to one example, the evaluation circuit 5 includes a plurality of second terminals 52 and a plurality of third terminals 53. In this example, the control electrodes 93 of a plurality of transistor devices 1 can be connected to respective third terminals 53 at the same time and the second load path electrodes 91 of the plurality of transistor devices can be connected to respective second terminals 52 at the same time. Nevertheless, the individual transistor devices 1 of the plurality of transistor devices that have their control electrodes 93 and second load path electrodes 92 connected to third and second terminals 53, 52 of the evaluation circuit 5 at the same time are measured successively.

It should be noted, that the method is not restricted to be used with vertical transistor devices. The method may also be used to determine the charge stored in the first internal capacitance in a lateral transistor device, in which the control node and the first and second load path node are accessible on the same side of the semiconductor body that includes the transistor device. For testing lateral transistor devices, the first terminal may be implemented as a needle instead of a plate.

Some aspects of the transistor device and the method explained above are briefly summarized in the following.

One example relates to a method that includes applying a voltage with a predefined voltage level between a first load path node and a second load path node of a transistor device; measuring a voltage between a control node and the second load path node to obtain a voltage measurement value; and determining at least one of an electric charge stored in a first internal capacitance or a capacitance value of the internal capacitance effective between the first load path node and the control node based on the first voltage measurement value and based on a capacitance value of a second internal capacitance effective between the control node and the second load path node.

According to one example, the method further includes determining the capacitance value of the second internal capacitance. Determining the capacitance value of the second internal capacitance may include charging the second internal capacitance in a charging process; and determining the capacitance value of the second internal capacitance based on a charge provided to the second internal capacitance in the charging process and based on a change of a voltage between the control node and the second load path node in the charging process.

According to one example, the method further includes connecting an external capacitance between the control node and the second load path node when applying the voltage with the predefined voltage level between the first load path node and the second load path node; and determining the electric charge stored in the first internal capacitance further based on a capacitance value of the external capacitance.

According to one example, the transistor device is integrated in a semiconductor body and the semiconductor body is one of a plurality of semiconductor bodies of a wafer

The transistor device is an insulated gate transistor device, such as a MOSFET or an IGBT, for example.

According to one example, applying the voltage with the predefined voltage level between the first load path node and the second load path node and measuring the voltage between the control node and the second load path node comprises using an evaluation circuit. The evaluation circuit may include a first terminal configured to be coupled to the first load path node, a second terminal configured to be coupled to the second load path node, and a third terminal configured to be coupled to the control node. The evaluation circuit may further include a first parasitic capacitance between the first terminal and the third terminal and a second parasitic capacitance between the third terminal and the second terminal, and wherein determining the electric charge stored in the first internal capacitance may further include determining the capacitance value based on capacitance values of the first parasitic capacitance and the second parasitic capacitance.

According to one example, the predefined voltage level of the voltage applied between the first load path node and the second load path node is selected such that a voltage between the control node and the second load path node resulting from the voltage applied between the first load path node and the second load path node is lower than a threshold voltage of the transistor device.

According to one example, a polarity of the voltage applied between the first load path node and the second load path node is such that an internal diode of the transistor device between the first load path node and the second load path node is reverse biased.

According to one example, the method further includes determining a capacitance value of the first internal capacitance based on the determined electric charge stored in the first internal capacitance and a difference between the voltage level of the load path voltage and the voltage level of the measured voltage between the control node and the second load path node.

According to another example, the method explained above is used for determining at least one of an electric charge stored in a first internal capacitance or a capacitance value of a first internal capacitance of each of a plurality of transistor devices integrated in a wafer. According to one example, this method includes determining the at least one of the electric charge stored in the first internal capacitance or the capacitance value of each of the plurality of transistor devices successively.

Yet another example relates to an evaluation circuit that includes a first terminal configured to be coupled to a first load path node of a transistor device; a second terminal configured to be coupled to a second load path node of the transistor device; and a third terminal configured to be coupled to a control node of the transistor device. The evaluation circuit is configured to determine a capacitance value of a first internal capacitance of the transistor device in accordance with the method explained hereinabove. According to one example, the evaluation circuit further includes an external capacitance between the third terminal and the second terminal. According to one example, each of the first terminal and the third terminal includes a contact needle, and the second terminal includes a contact plate or a contact needle.

**Claims**

1. A method, comprising:

   applying a voltage with a predefined voltage level between a first load path node (11) and a second load path node (12) of a transistor device (1);
   measuring a voltage between a control node (13) and the second load path node (12) to obtain a voltage measurement value; and
   determining at least one of an electric charge stored in a first internal capacitance (21) or a capacitance value (C21) of the internal capacitance (21) effective between the first load path node (11) and the control node (13) based on the first voltage measurement value and based on a capacitance value of a second internal capacitance (31) effective between the control node (13) and the second load path node (12).

2. The method of claim 1, further comprising:
   determining the capacitance value of the second internal capacitance (31).

3. The method of claim 2, wherein determining the capacitance value of the second internal capacitance (31) comprises:

   charging the second internal capacitance (31) in a charging process; and
   determining the capacitance value of the second internal capacitance (31) based on a charge provided to the second internal capacitance (31) in the charging process and based on a change of a voltage between the control node (13) and the second load path node (12) in the charging process.

4. The method according to any one of claims 1 to 3, further comprising:

   connecting an external capacitance (33) between the control node (13) and the second load path node (12) when applying the voltage with the predefined voltage level between the first load path node (11) and the second load path node (12); and
   determining the electric charge stored in the first internal capacitance (21) further based on a capacitance value of the external capacitance.

5. The method according to any one of claims 1 to 4,

   wherein the transistor device (1) is integrated in a semiconductor body (100), and
   wherein the semiconductor body (100) is one of a plurality of semiconductor bodies of a wafer (200).

6. The method according to any one of claims 1 to 5,
   wherein the transistor device (1) is an insulated gate transistor device.

7. The method according to claim 6,
   wherein the transistor device (1) is a MOSFET or an IGBT.

8. The method according to any one of claims 1 to 7,

   wherein applying the voltage with the predefined voltage level between the first load path node (11) and the second load path node (12) and wherein measuring the voltage between the control node (13) and the second load path node (12) comprises using an evaluation circuit (5),
   wherein the evaluation circuit (5) comprises a first terminal (51) configured to be coupled to the first load path node (11), a second terminal (52) configured to be coupled to the second load path node (12), and a third terminal (53) configured to be coupled to the control node (13).

9. The method according to claim 8,

   wherein the evaluation circuit (5) comprises a first parasitic capacitance (22) between the first terminal (51) and the third terminal (53) and a second parasitic capacitance (32) between the third terminal (53) and the second terminal (52), and

wherein determining the electric charge stored in the first internal capacitance (21) further comprises determining the capacitance value based on capacitance values of the first parasitic capacitance (22) and the second parasitic capacitance (32).

10. The method according to any one of claims 1 to 9,
wherein the predefined voltage level of the voltage applied between the first load path node (11) and the second load path node (12) is selected such that a voltage between the control node (13) and the second load path node (12) resulting from the voltage applied between the first load path node (11) and the second load path node (12) is lower than a threshold voltage of the transistor device.

11. The method according to any one of claims 1 to 10,
wherein a polarity of the voltage applied between the first load path node (11) and the second load path node (12) is such that an internal diode of the transistor device between the first load path node (11) and the second load path node (12) is reverse biased.

12. The method according to any one of claims 1 to 11, further comprising:

determining a capacitance value (C21) of the first internal capacitance (21) based on
the determined electric charge (Q21) stored in the first internal capacitance (21) and
a difference between the voltage level of the load path voltage and the voltage level of the measured voltage between the control node (31) and the second load path node (12).

13. A method comprising:
determining at least one of an electric charge stored in a first internal capacitance (21) or a capacitance value (C21) of a first internal capacitance (21) of each of a plurality of transistor devices integrated in a wafer (200) using a method according to any one of claims 1 to 12.

14. The method according to claim 13,
wherein determining the at least one of the electric charge stored in the first internal capacitance (21) or the capacitance value of each of the plurality of transistor devices (1) comprises successively determining the at least one of the electric charge or the capacitance value of the plurality of transistor devices (1).

15. An evaluation circuit, comprising

a first terminal (51) configured to be coupled to a first load path node (11) of a transistor device (1);
a second terminal (52) configured to be coupled to a second load path node (12) of the transistor device (1); and
a third terminal (53) configured to be coupled to a control node (13) of the transistor device (1), and
configured to determine a capacitance value of a first internal capacitance (21) of the transistor device (1) in accordance with the method according to any one of claims 1 to 12.

16. The evaluation circuit according to claim 15, further comprising:
an external capacitance (33) between the third terminal (53) and the second terminal (52).

17. The evaluation circuit according to claim 15 or 16,

wherein each of the first terminal (51) and the third terminal (53) includes a contact needle, and
wherein the second terminal (52) includes a contact plate or a contact needle.

FIG 1

FIG 2

| APPLYING A VOLTAGE WITH A PREDEFINED VOLTAGE LEVEL BETWEEN THE FIRST LOAD PATH NODE AND THE SECOND LOAD PATH NODE OF THE TRANSISTOR DEVICE | 1001 |

| MEASURING A VOLTAGE BETWEEN THE CONTROL NODE AND THE SECOND LOAD PATH NODE TO OBTAIN A VOLTAGE MEASUREMENT VALUE | 1002 |

| DETERMINING AN ELECTRIC CHARGE STORED IN THE FIRST INTERNAL CAPACITANCE BASED ON THE VOLTAGE MEASUREMENT VALUE AND BASED ON A CAPACITANCE VALUE OF THE SECOND INTERNAL CAPACITANCE | 1003 |

FIG 3

FIG 4

FIG 5

FIG 6

FIG 7

FIG 8

FIG 9

FIG 10

**FIG 11**

**FIG 12**

| | Europäisches Patentamt European Patent Office Office européen des brevets | **EUROPEAN SEARCH REPORT** | **Application Number** EP 24 18 7019 |

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | DE 10 2007 026784 A1 (ISLE GMBH [DE]) 24 December 2008 (2008-12-24) * paragraph [0003] - paragraph [0300] * * figures 1-203 * ----- | 1-17 | INV. G01R27/26 G01R31/26 H01L21/66 G01R29/24 |
| A | US 2021/255235 A1 (GRAF ALFONS [DE]) 19 August 2021 (2021-08-19) * paragraph [0042] - paragraph [0059] * * figures 1-20 * ----- | 1-17 | |

| | TECHNICAL FIELDS SEARCHED (IPC) |
|---|---|
| | G01R H01L |

The present search report has been drawn up for all claims

| Place of search | Date of completion of the search | Examiner |
|---|---|---|
| Munich | 13 December 2024 | Sedlmaier, Stefan |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 24 18 7019

This annex lists the patent family members relating to the patent documents cited in the above-mentioned European search report.
The members are as contained in the European Patent Office EDP file on
The European Patent Office is in no way liable for these particulars which are merely given for the purpose of information.

13-12-2024

| Patent document cited in search report | Publication date | Patent family member(s) | Publication date |
|---|---|---|---|
| DE 102007026784 A1 | 24-12-2008 | NONE | |
| US 2021255235 A1 | 19-08-2021 | CN 113341290 A<br>DE 102020103874 B3<br>US 2021255235 A1 | 03-09-2021<br>10-06-2021<br>19-08-2021 |

EPO FORM P0459

For more details about this annex : see Official Journal of the European Patent Office, No. 12/82